# EUROPÄISCHE PATENTSCHRIFT

(11) **EP 1 145 285 B1**
(45) Veröffentlichungstag und Bekanntmachung des Hinweises auf die Patenterteilung: **03.05.2006**
(21) Anmeldenummer: 99957836.2
(22) Anmeldetag: 21.12.1999
(51) Int. Cl.: H01L 21/00

(54) **HANDWERKZEUG ZUR MONTAGE KLEINER, INSBESONDERE ELEKTRONISCHER BAUTEILE**
HAND TOOL FOR THE ASSEMBLY OF SMALL, NOTABLY ELECTRONIC, COMPONENTS
OUTIL A MAIN POUR LE MONTAGE DE PETITS COMPOSANTS, EN PARTICULIER ELECTRONIQUES

(30) Priorität: 31.12.1998 CH 258898
(43) Veröffentlichungstag der Anmeldung: 17.10.2001
(73) Patentinhaber: Tresky, Miroslav, 8803 Rüschlikon (CH)
(72) Erfinder: Tresky, Miroslav, 8803 Rüschlikon (CH)
(74) Vertreter: Spicak-Malcova, Hana
(86) Internationale Anmeldenummer: PCT/CH1999/000614
(87) Internationale Veröffentlichungsnummer: WO 2000/041218

(56) Entgegenhaltungen:
- WO-A-97/32460
- CH-A- 673 251
- DE-A- 3 721 226

## Beschreibung

Die Erfindung betrifft ein Handwerkzeug zur Montage kleiner, insbesondere elektronischer Bauteile gemäss dem Oberbegriff des Anspruches 1.

Ein Handwerkzeug dieser Art ist beispielsweise aus der WO 89/04547 bekannt. Das Handwerkzeug weist einen mit einem Handgriff versehenen Stiel und einen vorderen Kopfteil auf, in welchem eine ein Vakuumwerkzeug aufnehmende Spindel angeordnet ist. Die Spindel- bzw. Vakuumwerkzeugachse bildet einen konstanten Winkel mit der Stielachse. Die Spindel ist auf ihrem oberen Ende mit einem Drehknopf versehen, mittels welches eine Drehverstellung der Spindel und somit auch des Vakuumwerkzeuges zwecks Positionierung des angesaugten Bauteiles erfolgt. Der Drehknopf wird in der Regel mit dem Zeigefinger betätigt, während das Handwerkzeug bzw. der Handgriff desselben zwischen dem Daumen und den übrigen Fingern gehalten wird. Der untenliegende Mittelfinger ist länger als der Zeigefinger, was eine Sichtbeeinträchtigung bezüglich des Bauteils und des zu bestückenden Objektes zur Folge haben kann. Es besteht die Gefahr, dass der Bauteil bzw. das zu bestückende Objekt in unerwünschter Weise mit den untenliegenden Fingern berührt wird. Um dies zu verhindern, ist eine besondere Konzentration der Bedienungsperson erforderlich. Oft ist eine unnatürliche, ermüdende Haltung die Folge, wodurch die Arbeitsqualität beeinträchtigt wird.

Der vorliegenden Erfindung liegt die Aufgabe zugrunde, ein Handwerkzeug der eingangs genannten Art zu schaffen, das eine bequeme und störungsfreie Handhabung ermöglicht.

Diese Aufgabe wird erfindungsgemäss durch ein Handwerkzeug mit den Merkmalen des Anspruches 1 gelöst.

Wetere vorteilhafte Ausgestaltungen des erfindungsgemässen Handwerkzeuges bilden den Gegenstand der abhängigen Ansprüche.

Dadurch, dass die Drehknopfachse gegenüber der Spindel- bzw. Vakuumwerkzeugachse in einem Abstand angeordnet und in Richtung zum Handgriff hin versetzt ist, wobei eine Antriebsverbindung zwischen dem Drehknopf und der Spindel vorhanden ist, wird die Gefahr der Sichtbeeinträchtigung bezüglich des Bauteiles und des zu bestückenden Objektes und der unerwünschten Berührung während des Bestückungsvorganges weitgehend eliminiert und eine ergonomisch vorteilhafte Ausgestaltung des Handwerkzeuges erreicht.

Mit Vorteil wird die Antriebsverbindung zwischen dem Drehknopf und der Spindel mittels dem Drehknopf und der Spindel zugeordneter, geradeverzahnter Stirnräder, die über ein Zwischenrad wirkverbunden sind, realisiert. Bei einer durch Berührung des Vakuumwerkzeuges mit dem Bauteil axial verstellbaren Spindel bildet in bevorzugter Weise das mit der Spindel verbundene Stirnrad einen Teil einer Schaltvorrichtung zur Signalabgabe an eine externe Steuerung des Ein- und Ausschaltens von Vakuum, die beispielsweise als ein mechanisches Kontaktpaar oder als ein elektronischer Sensor ausgebildet werden kann. Die gerade Verzahnung des Spindelrades ist besonders vorteilhaft, da bei der axialen Verstellung der Spindel keine zusätzliche Spindelrotation entsteht. Sowohl die Antriebsverbindung als auch die Steuerung des Ein- und Ausschaltens von Vakuum erfolgt in einfacher Weise.

In bevorzugter Weise umfasst der sich zwischen dem Stiel und der externen Steuerung erstreckende, flexible Verbindungsteil der elektropneumatischen Verbindung zwischen dem Vakuumwerkzeug und Steuerung einen äusseren, die elektrostatische Aufladung ableitenden Schlauch aus elektrisch leitfähigem Material, wodurch die Problematik der elektrostatischen Aufladung, die beispielsweise durch Reibung des flexiblen Verbindungsteiles auf einer Unterlage verstärkt werden kann und die sogar eine Beschädigung des zu behandelnden Bauteils zur Folge haben und den Arbeitsvorgang stark beeinträchtigen kann, gelöst wird. Mit Vorteil bildet der Schlauch gleichzeitig den pneumatischen Verbindungsteil, d.h. den Vakuumkanal, durch welchen auch die elektrischen Leitungen vorzugsweise in Form einer isolierten Litze und eines nicht isolierten Seils, vorzugsweise Stahlseils geführt werden.

Dadurch, dass der elastische Verbindungsteil in bevorzugter Weise über einen elektropneumatischen Stecker mit der Steuerung verbindbar ist, der sowohl pneumatische, als auch elektrische Verbindungselemente aufweist, wird eine einfachere, autonome Montage des Handwerkzeuges und der Steuerung ermöglicht. Ausserdem kann das Handwerkzeug fachgerecht, separat vom viel grösseren Steuerungkasten, für den Transport verpackt und auch als Ersatzteil geliefert werden.

Bei einer bevorzugter Ausgestaltung des Handwerkzeuges wird das einen elektrischen Verbindungsteil bildende Seil im Stiel einerseits und im elektropneumatischen Stecker anderseits fest verankert und als ein Zugentlastungselement für andere Verbindungen (Schlauch, Litze) vorgesehen, deren unvorgesehenes Ausreissen aus dem Stiel oder aus dem Stecker dadurch verhindert wird. Gleichzeitig dient es als Erdung und leitet die elektrostatische Aufladung durch die Wand des aus elektrisch leitfähigem Material angefertigten Schlauches.

Für eine besonders ergonomische Handhabung ist der Stiel mit einem im Querschnitt erweiterten Endstück ausgestattet, mit welchem das Handwerkzeug in eine gabelförmige, in einer ergonomisch optimalen Stellung vorzugsweise am Steuerungsgehäuse fixierbare Halterung während des Nichtgebrauchs einhängbar ist.

Ein Ausführungsbeispiel der erfindungsgemässen Vorrichtung ist in der Zeichnung dargestellt und im folgenden näher beschrieben.

Es zeigen:
- Fig. 1: in Ansicht ein Handwerkzeug in einer Ruhestellung, in einer an einem Steuerungsgehäuse befestigten Halterung eingehängt;
- Fig. 2: im vergrösserten Massstab und im Schnitt einen vorderen Teil des in Fig. 1 dargestellten Handwerkzeuges in einer Arbeitsstellung;
- Fig. 3: im vergrösserten Massstab und im Teilschnitt einen hinteren Teil des in Fig. 1 dargestellten Handwerkzeuges in der der Fig. 2 entsprechenden Arbeitsstellung, mit einem flexiblen elektropneumatischen Verbindungsteil und einem inneren Teil eines elektropneumatischen Steckers;
- Fig. 4: einen elektropneumatischen Stecker des elektopneumatischen Verbindungsteiles nach Fig. 3 in Frontansicht, in Pfeilrichtung S gesehen; und
- Fig. 5: eine für den Stecker nach Fig. 4 vorgesehene Steckdose in Frontansicht.

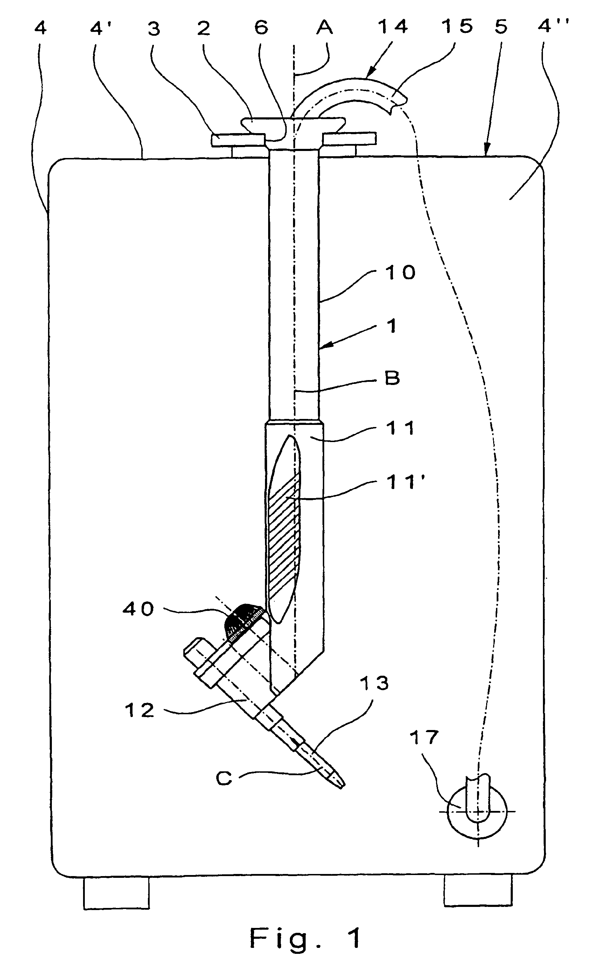

Fig. 1 zeigt ein. Handwerkzeug 1 zur Montage kleiner, insbesondere elektronischer Bauteile, das in einer Ruhestellung, d.h. während des Nichtgebrauchs mit seinem hinteren, im Querschnitt erweiterten Endstück 2 in einer gabelförmigen Halterung 3 eingehängt ist. Die Halterung 3 ist an einer oberen Wand 4' eines Gehäuses 4 befestigt, in welchem eine Steuerung 5 der elektropneumatischen Aktivierung des Handwerkzeuges 1 bzw. des Ein- und Ausschaltens von Vakuum untergebracht ist. Die Halterung 3 ist vorzugsweise mit dem Gehäuse 4 verschraubt und von diesem beispielsweise beim Transport der ganzen Anlage abnehmbar (in Fig. 1 ist lediglich eine Befestigungsachse A angedeutet, die Befestigungsschraube selber ist aus Fig. 1 nicht ersichtlich). Während in Fig. 1 eine rechtwinklige Stellung des U-förmigen Schlitzes 6 der Halterung 3 gegenüber einer vorderen Gehäusewand 4" dargestellt ist, ist es auch möglich, die Halterung 3 in einer anderen, um die Befestigungsachse A verschwenkten Stellung zu befestigen, in der der U-förmige Schlitz 6 unter einem Winkel zur vorderen Gehäusewand 4" steht. In dieser Weise kann eine ergonomisch optimale Bereitstellung des Handwerkzeuges 1 vorbereitet werden, die je nach Anordnung der Steuerung 5 am Arbeitsplatz, d.h. je nach dem, ob sich die Steuerung 5 links oder rechts zur Bedienungsperson befindet, oder ob es sich bei der Bedienungsperson um einen Recht- oder Linkshänder handelt, optimal eingestellt werden kann.

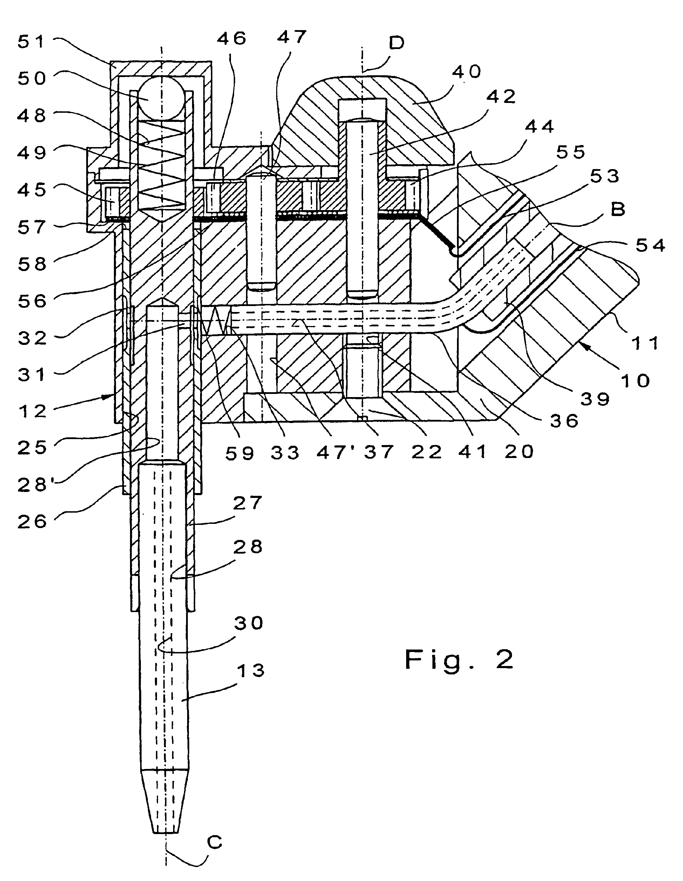

Das Handwerkzeug 1 weist einen Stiel 10 auf, der mit einem Handgriff 11 versehen ist. In einem Kopfteil 12 des Handwerkzeuges 1 ist ein Vakuumwerkzeug 13 angeordnet, wie weiter unten anhand der Fig. 2 ausführlich beschrieben wird. Die Stielachse B und die Spindelachse C bilden einen konstanten Winkel. Bei einer senkrecht zu einer Arbeitsfläche gerichteten Spindelachse C ist die Stielachse B vorzugsweise in einem Winkel von 45° zur Arbeitsebene geneigt (diese Stellung zeigt Fig. 2). Das Vakuumwerkzeug 13 ist über einen Drehknopf 40 drehverstellbar, der sich in unmittelbarer Nähe des mit Handgrifflächen 11' versehenen Handgriffes 11 befindet, und der beim Ergreifen des Handgriffes 11 in der Regel mit dem Zeigefinger betätigt wird. Die übertragung der Drehbewegung vom Drehknopf 40 auf das Vakuumwerkzeug 13 wird ebenfalls weiter unten anhand der Fig. 2 ausführlich beschrieben.

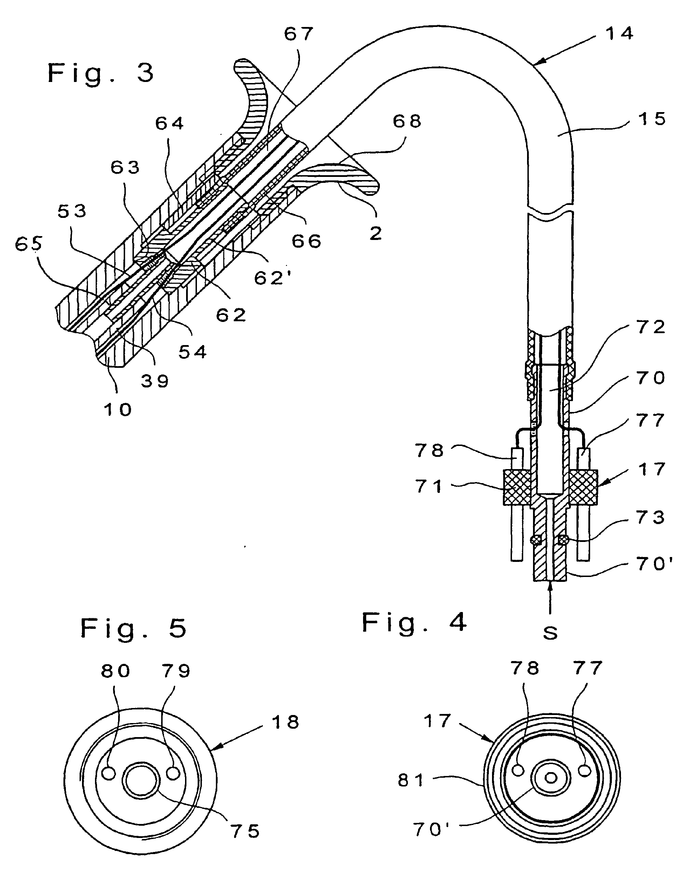

An dem dem Kopfteil 12 abgewandten, mit dem Endstück 2 versehenen Ende des Stieles 10 ist - wie insbesondere aus Fig. 3 ersichtlich - ein flexibler Verbindungsteil 15 einer elektropneumatischen, zwischen dem Vakuumwerkzeug 10 und der Steuerung 5 bestehenden Verbindung 14 befestigt. Der flexible Verbindungsteil 15 (in Fig. 1 teilweise nur schematisch strichpunktiert angedeutet) ist mit einem elektropneumatischen Stecker 17 ausgestattet, der aus Fig. 3 und 4 ersichtlich ist, und der in eine im Gehäuse 4 eingebaute Steckdose 18 (Fig. 5) der Steuerung 5 einsteckbar ist.

Gemäss Fig. 2 ist der im wesentlichen hülsenförmige Stiel 10 mit einem unteren Trägerteil 20 versehen, auf welchem der Kopfteil 12 angeordnet und mittels einer Befestigungsschraube 22 befestigt ist. Der Kopfteil 12 weist eine Bohrung 25 auf, in welcher eine Spindelbüchse 26 eingesetzt ist. In der Spindelbüchse 26 ist eine Spindel 27 sowohl drehbar, als auch axial verschiebbar gelagert. In einer axialen Ausnehmung 28 der Spindel 27 ist das Vakuumwerkzeug 13 eingesetzt und von der Spindel spannzangenartig festgehalten. Ein axialer Vakuumkanal 30 des Vakuumwerkzeuges 13 mündet in einen im Durchmesser abgesetzten Teil 28' der Ausnehmung 28, der über eine radiale Verbindungsbohrung 31 mit einem zwischen der Spindelbüchse 26 und der Bohrung 25 des Kopfteils 12 vorhandenen Ringraum 32 verbunden ist. In den Ringraum 32 mündet anderseits eine zur Spindelachse C bzw. zur Achse der Bohrung 25 rechtwinklig angeordnete Bohrung 33 im Kopfteil 12. Ein einen Vakuumkanal 37 bildendes, zwei unter einem Winkel zueinander geneigte Teile aufweisendes Rohr 36 aus elektrisch leitfähigem Material ragt einerseits in die Bohrung 33 des Kopfteils 12 und anderseits in ein zur Stielachse B koaxiales, im hülsenförmigen Stiel 10 angeordnetes Vakuumrohr 39 hinein.

Parallel zur Spindelachse C, und zwar näher zum Handgriff 11 des Stieles 10 hin, ist in einer Bohrung 41 des Kopfteils 12 eine feste Achse 42 für ein mit dem Drehknopf 40 drehfest verbundenes Antriebsrad 44 angeordnet. Die Drehknopfachse ist in Fig. 2 mit D bezeichnet. Gegebenenfalls ist die Bohrung 41 sowohl für die feste Achse 42, als auch für die Befestigungsschraube 22 vorgesehen. Die Spindel 27 ist drehfest mit einem Spindelzahnrad 45 verbunden. Das Spindelzahnrad 45 steht über ein Zwischenrad 46 in einer Antriebsverbindung mit dem Antriebsrad 44. Das Zwischenrad 46 ist an einer weiteren, im Kopfteil 12 fest in einer Bohrung 47' angeordneten Zwischenachse 47 drehbar angeordnet. Somit steht auch die das Vakuumwerkzeug 13 aufnehmende Spindel 27 in einer Antriebsverbindung mit dem Drehknopf 40, wobei die Drehrichtung des Drehknopfes 40 gleich ist, wie die Drehrichtung der Spindel 27. Alle Zahnräder 44, 45, 46 sind als geradeverzahnte Stirnräder ausgebildet.

Die Spindel 27 weist auf ihrem der Ausnehmung 28 abgewandten Ende eine weitere axiale Ausnehmung 48 auf, aus welcher eine Kugel 50 hinausragt und von einer Feder 49 an eine mit dem Kopfteil 12 verbundenen Haube 51 angedrückt wird. Die Kugel 50 bewirkt eine praktisch reibungsfreie Abstützung der verdrehbaren Spindel 27 an der Haube 51.

Der elektrische Teil der elektropneumatischen Verbindung 14 zwischen dem Vakuumwerkzeug 13 und der externen Steuerung 5 umfasst eine isolierte Litze 53 sowie ein nicht isoliertes Seil 54 aus elektrisch leitfähigem Material, vorzugsweise aus Stahl. Die durch den hülsenförmigen Stiel 10 am Umfang des Vakuumrohres 39 geführte Litze 53 ist mit einer unterhalb von Zahnrädern 44, 45, 46 angeordneten, auf einer oberen Fläche 56 des Kopfteils 12 angebrachten Kontaktplatte 55 elektrisch verbunden. Das Spindelzahnrad 45 bildet mit seiner unteren Stirnfläche eine mit der Kontaktplatte 55 wirkverbundene Kontaktfläche 57. Eine obere Stirnfläche 58 der Spindelbüchse 26 liegt in einem Abstand von der Kontaktplatte 55.

Das ebenfalls durch den hülsenförmigen Stiel 10 am Umfang des Vakuumrohres 39 geführte Seil 54 steht mit dem Rohr 36 in elektrischer Verbindung. Das Rohr 36 ist über eine einen sicheren Kontakt garantierende Feder 59 mit der Spindelbüchse 26, der Spindel 27 und dem Spindelzahnrad 45 elektrisch verbunden. Bei der in Fig. 2 dargestellten Stellung der Spindel 27 ist der elektrische Kreis über die auf der Kontaktplatte 55 aufliegende Kontaktfläche 57 des Spindelzahnrades 45 geschlossen.

Gemäss Fig. 3 ist im hinteren Bereich des hülsenförmigen Stieles 10 ein ebenfalls hülsenförmiger Nippel 62 in das Stielinnere eingesetzt, der sich an einer Stielabsatzfläche 63 abstützt und über eine Distanzhülse 64 von dem in das Stielende eingeschraubten Endstück 2 festgehalten wird. Ein in das Vakuumrohr 39 einerseits und in den Nippel 62 anderseits hineinragendes Rohr 65 verbindet die beiden Teile. Am Umfang des Rohres 65 sind sowohl die Litze 53 als auch das Seil 54 dichtend durch den Nippel 62 geführt und zumindest das Seil 54 im demselben fest verankert. Auf einen Ansatz 62' des Nippels 62 ist ein Schlauch 66 als ein Bestandteil des flexiblen Verbindungsteils 15 dichtend aufgestülpt und auf diesem befestigt. Der mit seinem Innern einen Vakuumkanal 67 bildende Schlauch 66, durch welchen die elektrischen Leitungen (Litze 53, Seil 54) bis zum Stecker 17 geführt sind, ist aus elektrisch leitfähigem oder zumindest elektrisch leitfähige Partikel aufweisendem Material angefertigt. Es kann sich beispielsweise um Silikon mit einem Graphitzusatz handeln.

Das in das Stielende eingeschraubte Endstück 2 ist im wesentlichen trichterförmig ausgebildet und mit einer kantenfreien inneren Fläche 68 ausgestattet, an der der aus dem Stiel 10 ausgeführte Schlauch 66 schonend anliegen kann.

Das dem Stiel 10 abgewandte Ende des Schlauches 66 ist auf ein Steckerrohr 70 des elektropneumatischen Steckers 17 dichtend aufgestülpt und mit demselben verbunden. Das vorzugsweise aus Messing angefertigte, einen Vakuumkanal 72 bildende Steckerrohr 70 ist in einem Steckerteil 71 befestigt und ragt mit seinem Teil 70' aus diesem hinaus. Der Teil 70' ist zum Einstecken in ein entsprechendes Gegenstück 75 der Steckdose 18 (Fig. 5) vorgesehen, wobei eine Dichtung 73 die pneumatische Verbindung des Steckers 17 mit der Steckdose 18 sichert.

Am Umfang des Steckerrohres 70 sind im Steckerteil 71 elektrische Kontaktstifte 77, 78 eingebaut. Für die Kontaktstifte 77, 78 weist die Steckdose 18 entsprechende Anschlussöffnungen 79, 80 auf (Fig. 5). Die elektrischen Leitungen (Litze 53, Seil 54) sind aus dem Steckerrohr 70 dichtend ausgeführt und jeweils in einem der Kontaktstifte 77, 78 verankert.

Die in Fig. 3 dargestellten Teile des elektropneumatischen Steckers 17 sind in einem in Fig. 3 nicht dargestellten Steckergehäuse untergebracht, das in Fig. 4 mit 81 bezeichnet ist und mit der Steckdose 18 verschraubt werden kann.

Die Länge des im Nippel 62 einerseits und im Kontaktstift 78 anderseits verankerten Seils 54 ist kleiner als die Länge der Litze 53 zwischen dem Nippel 62 und dem Kontaktstift 77. Somit übernimmt das Seil 54 eine Zugentlastungsfunktion für die anderen Teile des flexiblen Verbindungsteils 15 (Schlauch 66, Litze 53), so dass auch beispielsweise beim unvorgesehenem Herunterfallen des Handwerkzeuges 1 vom Arbeitspult und beim Hängenbleiben am flexiblen Verbindungsteil 15 keine Gefahr besteht, dass diese Teile rausgerissen werden.

Im folgenden werden nun die Funktionsweise und die besonderen Vorteile des erfindungsgemässen Handwerkzeuges 1 beschrieben.

Das Handwerkzeug wird von der Bedienungsperson am Handgriff 11 ergriffen und in die in Fig. 2 dargestellte Position gebracht. Bei Berührung des zu behandelnden Bauteiles mit dem Vakuumwerkzeug 13 wird das Vakuumwerkzeug 13 mit der Spindel 27 in der Spindelbüchse 26 entgegen der Kraft der Feder 49 nach oben gedrückt. Mit der Spindel 27 wird auch das Spindelzahnrad 45 angehoben und somit der Kontakt zwischen der Kontaktfläche 57 und der Kontaktplatte 55 unterbrochen. Durch das Unterbrechen des elektrischen Kreises wird ein Signal an die Steuerung 5 erteilt, das Vakuum wird eingeschaltet und der Bauteil an das Vakuumwerkzeug angesaugt. Die Bedienungsperson kann nun mit dem Zeigefinger den Drehknopf 40 verdrehen, um die gewünschte Positionierung des an das Vakuumwerkzeug 13 angesaugten Bauteiles zu erreichen. Dadurch, dass erfindungsgemäss die Spindelachse C in einem Abstand von der Drehknopfachse D angeordnet ist, wird gewährleistet, dass mit dem Zeigefinger bequem der in unmittelbarer Nähe vom Handgriff 11 angeordnete Drehknopf 40 erreicht wird und dabei keine Sichtbeeinträchtigung bezüglich des Bauteils bzw. des mit dem Bauteil zu bestückenden Objektes durch den unterliegenden Mittelfinger erfolgt. Somit wird auch die Gefahr weitgehend eliminiert, dass der Bauteil und/oder das Objekt in unerwünschten Weise mit dem Mittelfinger berührt und eventuell sogar beschädigt wird. Der Arbeitsvorgang wird dadurch für die Bedienungsperson wesentlich erleichtert.

Eine weitere Verbesserung des Arbeitsvorganges wird dadurch erzielt, dass nicht nur der Stiel 10 selber, sondern auch der Schlauch 66 des flexiblen Verbindungsteils 14 elektrisch leitfähig sind. Das nicht isolierte Seil 54 dient nicht nur zu der bereits erwähnten Zugentlastung, sondern auch als Erdung und leitet die elektrostatische Aufladung, die beispielsweise während des Bestückungsvorganges durch die Reibung des flexiblen Verbindungsteiles 14 auf einer Unterlage verstärkt werden kann, durch den elektrisch leitfähigen Schlauch 66 ab. Dadurch wird ein störungsfreier, ruhiger Arbeitsvorgang gewährleistet und die Gefahr, dass zur Beschädigung des Bauteils kommt, eliminiert. Es wäre allerdings auch möglich, die elektrischen Leitungen und den wie bisher aus nicht leitendem Material, z.B. aus Polyurethan oder einem anderen Kunststoff hergestellten Vakuumschlauch beispielsweise durch einen metallenen Netzschlauch zu führen und über diesen die elektrostatischen Aufladungen abzuleiten. Die erfindungsgemässe Lösung, bei der der Schlauch 66 aus elektrisch leitfähigem Material gleichzeitig den pneumatischen Verbindungsteil, d.h. den Vakuumschlauch bildet und die elektrischen Leitungen umgibt, ist jedoch insofern vorteilhafter, dass keine Gefahr des "Hängenbleibens", des Aufreissens, und somit auch keine Verletzungsgefähr wie bei einem Netz vorhanden ist.

Dadurch, dass der flexible Verbindungsteil 14 nicht direkt in der Steuerung 5 eingebaut ist, sondern über einen elektropneumatischen Stecker 17 mit der letzteren verbindbar ist, wird eine einfachere, autonome Montage des Handwerkzeuges 1 und der Steuerung 5 ermöglicht. Ausserdem kann das Handwerkzeug fachgerecht, separat vom viel grösseren Steuerungkasten, für den Transport verpackt und auch als Ersatzteil geliefert werden.

Beim dargestellten Ausführungsbeispiel stellt das Spindelrad 45 in Form eines mit der Spindel 27 axial verstellbaren Stirnrades einen Teil eines mechanischen Kontaktpaares 55, 57 dar. Es wäre aber auch möglich, zur Signalabgabe an die Steuerung 5 einen elektronischen Sensor zu verwenden, dessen einen Teil das Spindelrad 45 bildet. So könnte beispielsweise in der Haube 51 eine Spule eingebaut werden, deren Induktivität durch die axiale Verstellung des Spindelrades 45 veränderbar wäre.

Anstelle der Stirnrad-Antriebsverbindung zwischen dem Drehknopf 40 und der Spindel 27 könnte beispielsweise auch ein Reibungs- oder Riemenantrieb verwendet werden.

Statt der gabelförmigen Halterung 3 könnte selbstverständlich auch eine andere, beispielsweise schalenförmige Halterung zum Hineinlegen des Handwerkzeuges am Steuerungsgehäuse angebracht werden, allerdings ermöglicht die erfindungsgemässe Lösung wie bereits erwähnt eine ergonomisch besonders vorteilhafte Handhabung.

Das erfindungsgemässe Handwerkzeug ist insbesondere als ein Bestückungswerkzeug für mikroelektronische Baugruppen vorgesehen, kann jedoch auch in der Feinmechanik oder Optik Verwendung finden.

## Patentansprüche

1. Handwerkzeug zur Montage kleiner, insbesondere elektronischer Bauteile, mit einem mit einem Handgriff (11) versehenen Stiel (10) und mit einem Kopfteil (12), in welchem Kopfteil (12) eine ein Vakuumwerkzeug (13) aufnehmende, mittels eines Drehknopfes (40) drehverstellbare Spindel (27) gelagert ist, wobei die Spindelachse (C) einen konstanten Winkel mit der Stielachse (B) bildet, mit einer elektropneumatischen Verbindung (14) zwischen dem Vakuumwerkzeug (13) und einer externen Steuerung (5) des Ein- und Ausschaltens von Vakuum, und mit einer Schaltvorrichtung (55, 57) zur Signalabgabe an die Steuerung (5), **dadurch gekennzeichnet, dass** die Drehknopfachse (D) gegenüber der Spindelachse (C) in einem Abstand angeordnet und in Richtung zum Handgriff (11) hin versetzt ist, wobei eine Antriebsverbindung (44, 46, 45) zwischen dem Drehknopf (40) und der Spindel (27) vorhanden ist.

2. Handwerkzeug nach Anspruch 1, **dadurch gekennzeichnet, dass** ein mit dem Drehknopf (40) verbundenes Antriebsrad (44) über ein Zwischenrad (46) mit einem mit der Spindel verbundenen Spindelrad (45) in Antriebsverbindung steht, wobei die einzelnen Räder vorzugsweise als ineinandergreifende, geradeverzahnte Stirnräder ausgebildet sind.

3. Handwerkzeug nach Anspruch 2, mit einer im Kopfteil (12) bei Berührung des zu behandelnden Bauteiles mit dem Vakuumwerkzeug (13) axial verstellbaren Spindel (27), **dadurch gekennzeichnet, dass** das mit der Spindel (27) verbundene Spindelrad (45) einen Teil (57) der Schaltvorrichtung (55, 57) zur Signalabgabe an die Steuerung (15) bildet.

4. Handwerkzeug nach Anspruch 3, **dadurch gekennzeichnet, dass** das mit der Spindel (27) verbundene Spindelrad (45) einen Kontaktteil (57) eines mechanisch betätigbaren Kontaktpaares (55, 57) bildet.

5. Handwerkzeug nach Anspruch 3, **dadurch gekennzeichnet, dass** das mit der Spindel (27) verbundene Spindelrad (45) einen Teil eines elektronischen Sensors bildet.

6. Handwerkzeug nach einem der Ansprüche 1 bis 5, **dadurch gekennzeichnet, dass** die elektropneumatische Verbindung (14) zwischen dem Vakuumwerkzeug (13) und der Steuerung (5) einen sich zwischen dem Stiel (10) und der Steuerung (5) erstreckenden, flexiblen Verbindungsteil (15) umfasst, der einen äusseren, die elektrostatische Aufladung ableitenden Schlauch (66) aus elektrisch leitfähigem Material aufweist.

7. Handwerkzeug nach Anspruch 6, **dadurch gekennzeichnet, dass** der flexible Verbindungsteil (15) über einen elektropneumatischen Stecker (17) mit der Steuerung (5) verbindbar ist, der sowohl pneumatische, als auch elektrische Verbindungselemente (77, 78; 70) aufweist.

8. Handwerkzeug nach Anspruch 6 oder 7, **dadurch gekennzeichnet, dass** der Schlauch (66) einen Vakuumkanal (67) bildet, durch welchen die elektrischen Leitungen vorzugsweise in Form einer isolierten Litze (53) und eines nicht isolierten Seils (54), vorzugsweise aus Stahl, geführt sind.

9. Handwerkzeug nach Anspruch 7 und Anspruch 8, **dadurch gekennzeichnet, dass** das Seil (54) einerseits im Stiel (10) und anderseits im elektropneumatischen Stecker (17) fest verankert ist.

10. Handwerkzeug nach Anspruch 8 oder 9, **dadurch gekennzeichnet, dass** der Schlauch (66) aus Silikon mit einem Graphitzusatz hergestellt ist.

11. Handwerkzeug nach einem der Ansprüche 1 bis 10, **dadurch gekennzeichnet, dass** der Stiel (10) mit Mitteln (2) zum Einhängen des Handwerkzeuges (1) in einer vorzugsweise an einem Gehäuse (4) der Steuerung (5) angebrachten Halterung (3) während des Nichtgebrauchs versehen ist.

12. Handwerkzeug nach Anspruch 11, **dadurch gekennzeichnet, dass** die Mittel durch ein im Querschnitt erweitertes Endstück (2) des Stiels (10) gebildet sind, mit welchem das Handwerkzeug (1) in eine gabelförmige, in einer ergonomisch optimalen Stellung fixierbare Halterung (3) einhängbar ist.

## Claims

1. Hand tool for the assembly of small, notably electronic components, with a shaft (10) provided with a handle (11) and with a head part (12), in which head part (12) is mounted a spindle (27) housing a vacuum tool (13), said spindle (27) being adjusted by means of rotation using a turning knob (40), where the axis (C) of the spindle (27) forms a constant angle to the axis (B) of the shaft (10), with an electropneumatic connector (14) between the vacuum tool (13) and an external control device (5) for switching the vacuum on and off, and with a switch device (55, 57) to pass a signal to the control device (5), **characterised in that** the axis (D) of the turning knob (40) is located at a distance with respect to the axis (C)of the spindle (27) respectively and is offset towards the hand grip (11), where a driving connection (44, 46, 45) exists between the turning knob (40) and the spindle (27).

2. Hand tool according to Claim 1, **characterised in that** a drive wheel (44) connected to the turning knob (40) is connected via an intermediate wheel (46) to a spindle wheel (45) connected to the spindle in a driving connection, where the individual wheels are preferably in the form of meshing, straight-toothed spur wheels.

3. Hand tool according to Claim 2, with a spindle (27) in the head part (12) which can be displaced axially when the component to be handled is touched with the vacuum tool (13), **characterised in that** the spindle wheel (45) connected to the spindle (27) forms part (57) of the switching device (55, 57) for passing a signal to the control device (5).

4. Hand tool according to Claim 3, **characterised in that** the spindle wheel (45) connected to the spindle (27) forms one contact (57) of a mechanically actuated contact pair (55, 57).

5. Hand tool according to Claim 3, **characterised in that** the spindle wheel (45) connected to the spindle (27) forms part of an electronic sensor.

6. Hand tool according to one of Claims 1 to 5, **characterised in that** electropneumatic connector (14) between the vacuum tool (13) and an control device (5) comprises a flexible link (15), extending between the shaft (10) and the control device (5), which comprises an external tube (66) made of electrically-conductive material which discharges the electrostatic charge.

7. Hand tool according to Claim 6, **characterised in that** the flexible link (15) can be connected via an electropneumatic connector (17) with the control device (5), which connector (17) displays both pneumatic as well as electrical connection elements (77, 78; 70).

8. Hand tool according to Claims 6 or Claim 7, **characterised in that** the tube (66) forms a vacuum channel (67) through which the electrical wires, preferably in the form of an insulated flex (53) and an uninsulated cable (54), preferably made of steel, are guided.

9. Hand tool according to Claim 7 and Claim 8, **characterised in that** the cable (54) is permanently anchored, firstly to the shaft (10) and secondly to the electropneumatic connector (17).

10. Hand tool according to Claim 8 or 9, **characterised in that** the tube (66) is manufactured from silicon with added graphite.

11. Hand tool according to one of the claims 1 to 10, **characterised in that** the shaft (10) is provided with means (2) for mounting the hand tool (1) in a holder (3), preferably placed on a housing (4) of the control device (5) when not in use.

12. Hand tool according to Claim 11, **characterised in that** this means consists of an end piece (2) of the shaft (10) with an extended cross-section, with which the hand tool (1) can be mounted in a fork-shaped holder (3) which can be fixed into an ideal ergonomic position.

## Revendications

1. Outil à main pour le montage de petits composants, en particulier électroniques, comportant un manche (10) doté d'une poignée (11), et un élément de tête (12), dans lequel élément de tête (12) est disposée une broche (27) réglable en rotation à l'aide d'un bouton tournant (40), recevant un outil à vide (13), alors que l'axe de la broche (C) forme un angle constant avec l'axe du manche (B), comportant une connexion électropneumatique (14) entre l'outil à vide (13) et un dispositif de commande (5) externe pour l'activation et la désactivation du vide, et un dispositif de couplage (55, 57) pour la délivrance de signaux au dispositif de commande (5), **caractérisé en ce que** l'axe du bouton tournant (D) est disposé à une certaine distance par rapport à l'axe de la broche (C) et est décalé en direction de la poignée (11), une liaison d'entraînement (44, 46, 45) existant entre le bouton tournant (40) et la broche (27).

2. Outil à main selon la revendication 1, **caractérisé en ce qu'**une roue motrice (44) reliée au bouton tournant (40) est reliée pour l'entraînement au moyen d'une roue intermédiaire (46) à une roue à broche (45) reliée à la broche, les différentes roues étant de préférence configurées sous la forme de roues d'engrenage présentant des dentures droites, s'engrenant les unes dans les autres.

3. Outil à main selon la revendication 2, comportant une broche (27) pouvant être réglée axialement dans l'élément de tête (12) par mise en contact du composant à traiter avec l'outil à vide (13), **caractérisé en ce que** la roue à broche (45) reliée à la broche (27) forme un élément (57) du dispositif de couplage (55, 57) pour la délivrance de signaux au dispositif de commande (5).

4. Outil à main selon la revendication 3, **caractérisé en ce que** la roue à broche (45) reliée à la broche (27) forme un élément de contact (57) d'une paire de contacts (55, 57) pouvant être actionnée par voie mécanique.

5. Outil à main selon la revendication 3, **caractérisé en ce que** la roue à broche (45) reliée à la broche (27) forme un élément d'un capteur électronique.

6. Outil à main selon l'une quelconque des revendications 1 à 5, **caractérisé en ce que** la connexion électropneumatique (14) entre l'outil à vide (13) et le dispositif de commande (5) comprend un élément de raccordement (15) flexible, s'étendant entre le manche (10) et le dispositif de commande (5), lequel comporte un tuyau (66) extérieur, qui évacue la charge électrostatique, réalisé dans un matériau conducteur électrique.

7. Outil à main selon la revendication 6, **caractérisé en ce que** l'élément de raccordement (15) flexible est apte à être relié au dispositif de commande (5) par l'intermédiaire d'un connecteur électropneumatique(17), qui présente aussi bien des éléments de raccordement pneumatiques qu'électriques (77, 78 ; 70).

8. Outil à main selon l'une quelconque des revendications 6 ou 7, **caractérisé en ce que** le tuyau (66) forme un canal à vide (67), à travers lequel passent les circuits électriques, de préférence sous la forme d'un cordon isolé (53) et d'un câble non isolé (54), de préférence constitué en acier.

9. Outil à main selon l'une quelconque des revendications 7 ou 8, **caractérisé en ce que** le câble (54) est ancré fermement d'une part dans le manche (10), et d'autre part dans le connecteur électropneumatique (17).

10. Outil à main selon l'une quelconque des revendications 8 ou 9, **caractérisé en ce que** le tuyau (66) est constitué en silicone avec une addition de graphite.

11. Outil à main selon l'une quelconque des revendications 1 à 10, **caractérisé en ce que** le manche (10) est doté de moyens (2) permettant de suspendre l'outil à main (1) dans un support (3) de préférence appliqué sur un boîtier (4) du dispositif de commande (5) en cas de non utilisation.

12. Outil à main selon la revendication 11, **caractérisé en ce que** les moyens sont formés par une partie d'extrémité (2), évasée en coupe, du manche (10), grâce à laquelle l'outil à main (1) peut être suspendu dans un support (3) en forme de fourche, pouvant être fixé dans une position optimale d'un point de vue ergonomique.
